# EUROPEAN PATENT APPLICATION

(11) **EP 1 798 766 A2**
(43) Date of publication of application: **20.06.2007**
(21) Application number: 06077173.0
(22) Date of filing: 05.12.2006
(51) Int. Cl.: H01L 23/495

(54) **Method for forming leadframe assemblies**

(30) Priority: 15.12.2005 US 304989
(71) Applicant: Delphi Technologies, Inc., Troy, Michigan 48007 (US)
(72) Inventor: Djordjevic, Aleksandra, Kokomo, IN 46902 (US); Berlin, Carl W., West Lafayette, IN 47906 (US)
(74) Representative: Denton, Michael John

(57) **Abstract**

A method for forming a leadframe assembly (22) is provided. The method includes the steps of providing a sheet (10) of leadframe material and depositing a brazing alloy (12) on a first surface of the sheet (10). The method also includes the steps of placing one or more substrates (16) on the first surface of the sheet (10) and in contact the brazing alloy (12), and heating the brazing alloy (12) to bond the substrate (16) to the first surface of the sheet (10).

## Description

### Technical Field

The present invention generally relates to electronic circuit packaging, and more particularly, to a method for joining electronic circuit substrates to lead frame material to form leadframe assemblies.

### Background of the Invention

Electronic components and devices are employed in a wide variety of systems and applications. These devices are typically implemented as integrated circuits (ICs) that include multiple logical functions or sub-devices integrated into a single device. Because most electronic systems require the interconnection of a number of integrated circuits in order to perform a given function, leaded integrated circuit packages have been developed to facilitate electrical circuit interconnection. Examples of leaded integrated circuit packages include Quad Flat Pack (QFP), and Plastic Leaded Chip Carrier (PLCC). Various other package types exist.

The leads in leaded integrated circuit packages are designed to conduct electrical signals between the integrated circuit package and the electronic circuitry that is mounted in or on the integrated circuit package. In a typical package configuration, a semiconductor die is mounted on a copper leadframe having multiple leads. The leadframe may also be mounted on a substrate to provide, among other things, structural support and heat transfer capability. Electrical contacts on the semiconductor die are then connected to individual leads, typically by a wire-bonding process. After the wire-bonding process, the device is typically encapsulated in a material (such as plastic) to provide support and protection for the device, and to keep out moisture. The end result of the process is a device having leads capable of carrying electrical signals from the exterior pins or contacts of the device to the interior circuitry, or vice versa. Due to the small geometries involved, the process for making packaging structures onto which semiconductor devices are mounted can require a great deal of precision and can be quite expensive.

In integrated circuits having a leadframe attached to a substrate, the assembly is generally formed by a process that secures the leadframe to the substrate. In one conventional process for forming a leadframe assembly, a substrate material is provided. The substrate material is typically an electrically insulating material having a metallized coating on its surface. A metallic leadframe is then attached to the substrate by soldering. Prior to being attached to the substrate, the leadframe can be etched or stamped to form a pattern of leads and a die-mounting pad. In one exemplary soldering process, solder paste is deposited on the substrate, in a process called solder paste printing, before the leadframe is placed on the substrate. Next, a high-temperature solder reflow process melts the solder paste, securing the leadframe to the substrate. While this conventional soldering method for connecting a leadframe to a substrate does have utility, the nature of the solder paste and reflow process can make the joints connecting the leadframe to the substrate subject to failure due to cracking. When cracking of the joints occurs, the reliability of the device, and the system in which the device is used, can be negatively impacted.

In another conventional process for connecting a leadframe to a substrate, the leadframe is attached to the substrate by a brazing process. In this conventional process, a substrate, such as a ceramic, is first provided. The substrate could optionally be pre-scribed. The substrate material may have a metallized coating on its surface. Next, a brazing alloy is printed on various locations of the surface of the substrate. Copper leadframes are then placed on top of the areas of the substrate that have been printed with brazing alloy. Next, the entire structure (including the substrate, brazing alloy, and leadframes) is heated in an inert atmosphere, causing the brazing alloy to bond the leadframes to the surface of the substrate. Finally, individual devices are removed from the resulting structure by snapping or cutting the individual devices apart and scraping away adjacent substrate material underneath the leadframe.

This conventional brazing process often results in a device with higher reliability than a device made by the soldering process discussed above, due primarily to the elimination of the solder joints. In addition, devices made using the brazing process typically have better thermal and electrical conductivity than devices made using a soldering process. However, the conventional brazing process is often more expensive than the soldering process. This is due in part to the limited substrate size of certain substrate materials (typically no more than six inches long by six inches wide for ceramic substrates). Smaller substrates mean that fewer devices can be formed on a given substrate. The higher cost of the conventional process is also due to the fact that excess substrate material is frequently removed to form the circuit structures and leads, thereby wasting costly substrate material.

Although some conventional processes for connecting leadframes and substrates can be relatively low-cost, this low cost often comes at the expense of the reliability of the connections formed. While some processes offer more reliable connections and improved thermal and electrical conductivity, this improved reliability often comes at an increased cost. It is therefore desirable to provide for a cost-effective process for connecting leadframes and substrates that will result in leadframe assemblies having more reliable connections between the substrate and leadframe, and improved electrical and thermal conductivity.

### Summary of the Invention

In accordance with one aspect of the present invention, a method for forming a leadframe assembly is provided. The method includes the steps of providing a sheet comprising leadframe material, depositing a brazing alloy on a first surface of the sheet, and providing at least one substrate having a first surface that is primarily planar. The method also includes the steps of placing the first surface of the at least one substrate adjacent to the first surface of the sheet so that at least a portion of the substrate first surface overlaps and contacts the brazing alloy, and heating the brazing alloy to bond the substrate to the first surface of the sheet.

These and other features, advantages and objects of the present invention will be further understood and appreciated by those skilled in the art by reference to the following specification, claims and appended drawings.

### Brief Description of the Drawings

The present invention will now be described, by way of example, with reference to the accompanying drawings, in which:
FIG. 1 is a perspective view of a sheet of leadframe material provided in a method for forming leadframe assemblies, according to one embodiment of the present invention;
FIG. 2 is a perspective view of the sheet further illustrating deposition of a brazing alloy according to the method;
FIG. 3 is a perspective view of the sheet and brazing alloy further illustrating substrates to be joined to the sheet according to the method;
FIG. 4 is a perspective view of the joined sheet and substrate according to the method;
FIG. 5 is a perspective view of the joined sheet and substrates after having been heated in an oven;
FIG. 6 is a perspective view of the bottom of the leadframe assemblies, after an etching step of the method;
FIG. 7 is an enlarged view of a separated single leadframe assembly made by the method; and
FIG. 8 is a flow diagram illustrating the method for forming the leadframe assembly, according to one embodiment of the present invention.

### Description of the Preferred Embodiments

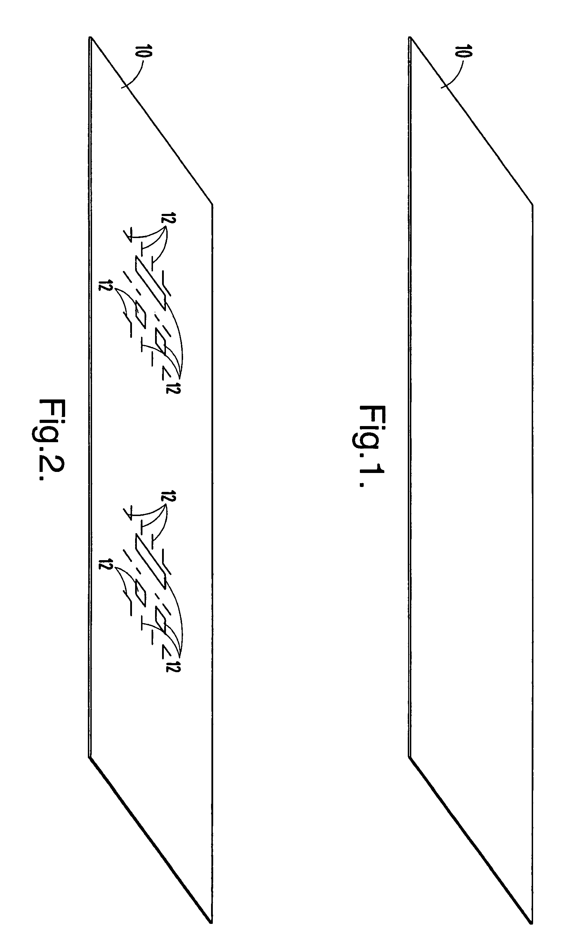

Referring to FIGS. 1-8, a method 100 for forming one or more leadframe assemblies 22 is generally illustrated, according to one exemplary embodiment of the present invention. The method 100, according to the present embodiment, forms one or more leadframe assemblies 22, in a cost-effective process that achieves reliable electrical circuit connections.

In FIG. 1, a sheet of leadframe material 10 is provided according to a first step of the method 100. As shown, sheet 10 is an unpatterned sheet having an upper first planar surface, an opposite second planar surface, and a length and width that are generally much greater than its thickness. In one embodiment, sheet 10 has a length of thirty-six inches and a width of thirty-six inches. Sheet 10 is made of a leadframe material that may be formed into leadframes. In one exemplary embodiment, sheet 10 is a thin copper sheet. Alternatively, sheet 10 could be a thick copper sheet. It should be appreciated that sheet 10 could alternatively be made of a metal or metal alloy other than copper, or any other electrical conducting material suitable for the forming of leadframes. Sheet 10 could additionally have leadframes and/or leads pre-patterned in its surface by stamping, pre-etching, or other processes.

In FIG. 2, the leadframe material sheet 10 is shown having a brazing alloy 12 deposited in multiple locations on its first surface according to a second step of the method 100. In the brazing alloy deposition step, brazing alloy 12 is shown deposited in both patterned and/or unpatterned (e.g., amorphous) shapes on one of the planar surfaces of sheet 10, such as by means of a screen printing process according to one embodiment. According to one embodiment, brazing alloy 12 is a brazing alloy, such as a copper-silver alloy. Alternatively, brazing alloy 12 could be another alloy including gold or other metals. Brazing alloy 12 could alternatively be an active brazing alloy. Brazing alloy 12 is shown deposited in multiple locations on the upper planar surface of sheet 10. Alternatively, brazing alloy 12 could be deposited in one location on the upper planar surface, covering up to one hundred percent (100%) of the upper planar surface of sheet 10. According to one exemplary embodiment in which brazing alloy 12 is screen printed onto sheet 10, the brazing alloy 12 has a minimum thickness of 0.2 mils after being deposited on the upper planar surface of sheet 10. It should be appreciated that processes other than a screen printing process could be employed to deposit brazing alloy 12 onto the upper planar surface of sheet 10, and that the brazing alloy 10, as deposited, could be of various shapes, sizes., and thicknesses.

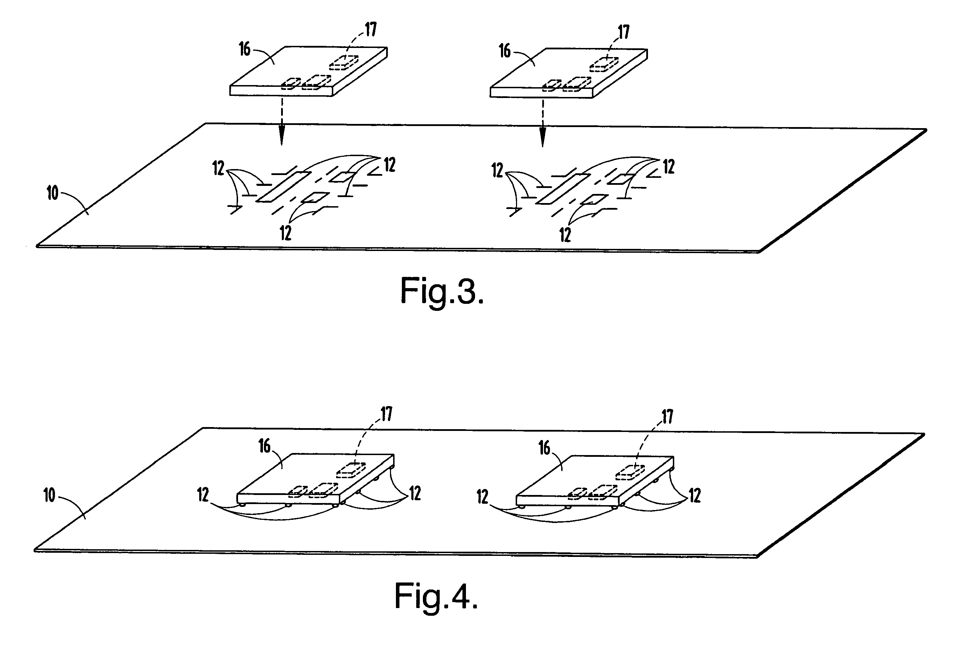

The leadframe material sheet 10 and brazing alloy 12 are further shown provided with substrates 16 in FIG. 3 following a third step of the method 100. The substrates 16 are made of a ceramic material, such as Aluminum Nitride, according to an exemplary embodiment. Substrates 16 are positioned above the upper planar surface of sheet 10 prior to placement on sheet 10, such that each substrate 16 at least partially overlaps an area of brazing alloy 12 that has been deposited on sheet 10. The substrates 16 could alternatively be made of materials other than aluminum nitride (AlN), such as silicon nitride (Si3N4), low-temperature co-fired ceramic (LTCC), or any other suitable substrate material, according to other embodiments. Each substrate 16 is also shown having circuitry 17 located within the substrate and extending to a first lower surface of the substrate 16 that is facing the upper planar surface of sheet 10. Alternatively, circuitry 17 may also be located on the first lower surface of substrate 16, or may be absent. Substrates 16 are also shown each having a size (length and width) substantially smaller than the size of sheet 10.

A fourth step of the method 100 is shown in FIG. 4 in which the first lower surface of each substrate 16 is placed onto the upper planar surface of leadframe material sheet 10 such that each substrate 16 overlaps, and is in contact with, brazing alloy 12. As shown, substrates 16 may be located such that some circuitry 17 located in substrate 16 is aligned and in contact with corresponding areas of brazing alloy 12. Alternatively, substrates 16 may be located such that circuitry 17 located in substrate 16 is not in contact with brazing alloy 12. Substrates 16 can be placed on sheet 10 manually, or automatically using automated placement equipment, such as a pick-and-place machine, according to one embodiment. In the embodiment shown, substrates 16 completely cover each location (area) of brazing alloy 12 on sheet 10. Alternatively, brazing alloy 12 may extend beyond the first upper planar surface of substrates 16. It should be appreciated that any number of substrates 16 may be placed on the first upper surface of sheet 10, and that substrates 16 may be placed in any number of patterns on the first upper surface of leadframe material sheet 10.

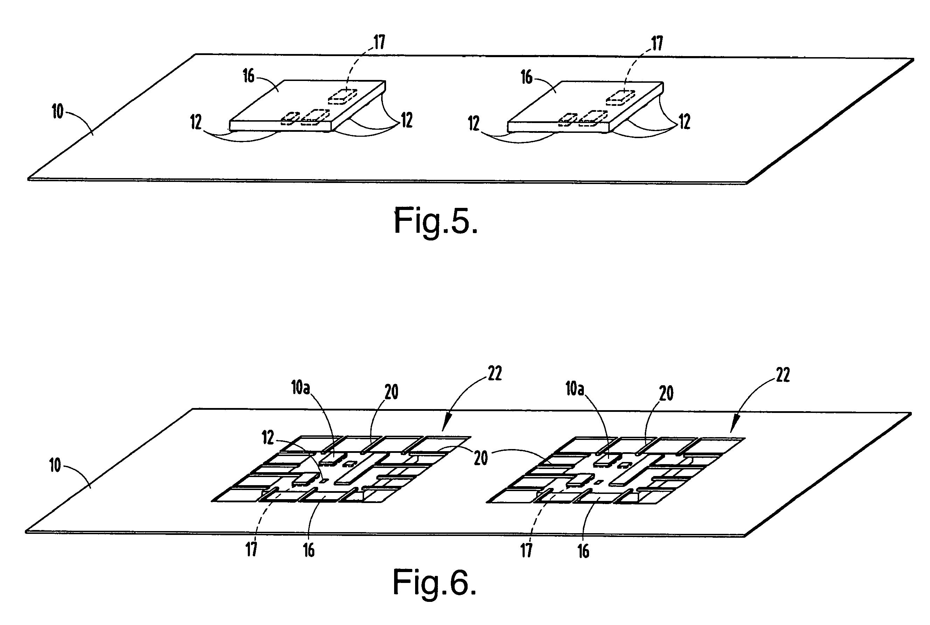

Next, the structure shown in FIG. 4 is heated in a furnace according to a fifth step of the method 100, resulting in the leadframe assembly shown in FIG. 5. The heating step causes brazing alloy 12 to bond the first lower surface of each of substrates 16 to the upper surface of leadframe material sheet 10. It should be appreciated that means other than a furnace may be used to heat the brazing alloy 12 to bond substrates 16 to the surface of sheet 10, provided that sufficient heat is applied to cause brazing alloy 12 to bond bottom planar substrates 16 to sheet 10. In one specific exemplary embodiment, the structure is heated in a furnace at greater than five hundred degrees Celsius (500°C) for forty-five minutes at atmospheric pressure.

The opposite bottom planar surface of sheet 10 is shown in FIG. 6, after some of copper sheet 10 has been etched away according to a sixth step of the method 100. The etching step results in the formation of leads 20 and copper pads 10a, and the exposure of elements of brazing alloy 12, circuitry 17, and substrate 16. The etching step may include application of an etchant, such as a ferric chloride solution, a peroxide-sulfuric-based solution, or other etchants capable of removing the material of sheet 10. It should be appreciated that, prior to the etching step, masking materials may be applied to the bottom planar surface of sheet 10, such that the etching results in a desired pattern of copper circuitry, copper pads 10a, brazing alloy 12, metallized circuitry 17, and substrate 16, forming leads and additional circuit elements and connecting structures.

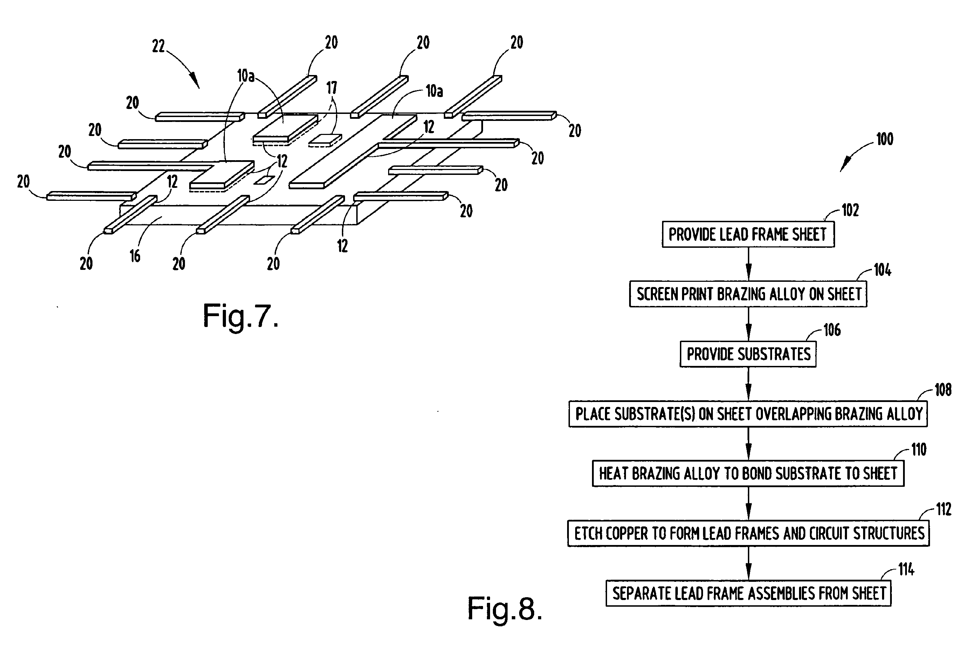

After the etching step has been completed, individual leadframe assemblies 22 may be separated from sheet 10 by cutting, breaking, or etching, in a seventh step of the method 100. FIG. 7 generally illustrates a single leadframe assembly 22 resulting from the exemplary process. The resulting leadframe assemblies 22 may be utilized for mounting semiconductor devices, which can be attached to assemblies 22 using, for example, conventional soldering practices. Although the present method advantageously provides contacts for electrically connecting devices attached to leadframe assemblies 22 to leads 20 without an additional wirebonding step, additional connections between devices attached to leadframe assemblies 22, or circuitry 10A formed as part of leadframe assembly 22, and leads 20 can optionally be formed by wirebonding. Completed assemblies 22 may be further encapsulated in a material, such as plastic, to protect the assembly 22 from damage and moisture. Leads 20 of assembly 22 may be trimmed or bent into various shapes and sizes.

It should be appreciated that various steps in the exemplary process illustrated in FIGS. 1-7 may be accomplished by automated means. For example, a conveyor can be employed for moving leadframe material sheet 10 through various automated processing stations. These stations may include screen printing stations for depositing brazing alloy 12 on sheet 10, pick-and-place stations for placing individual substrates 16 on sheet 10, heating stations for heating the assembly, etching stations for removing unwanted copper, and processing stations for separating individual leadframe assemblies 22 from sheet 10. Alternatively, one or more steps of method 100 may be achieved manually or with other equipment.

Referring to FIG. 8, the process steps of method 100 for joining at least one substrate to leadframe material to form a leadframe assembly are generally illustrated, according to one embodiment of the present invention. In the first step 102, a sheet made of leadframe material is provided. Next, in step 104, a brazing alloy is screen printed onto a first surface of the sheet. In step 106, at least one substrate is provided. In step 108, the at least one substrate is placed on the sheet of leadframe material, such that it overlaps, and is in contact with, the brazing alloy. Next, in step 110, the brazing alloy is heated in a furnace to bond the at least one substrate to the first surface of the sheet of leadframe material. In step 112, copper is etched from the sheet to form leadframe elements and circuit structures. Finally, in step 114, individual leadframe assemblies are separated from the sheet of leadframe material.

In one specific embodiment of the method 100, the leadframe material sheet 10 is made of copper, and has a length and width much greater than the thickness of the sheet 10. The copper sheet 10 is placed adjacent to a screen printing device, which then screen prints patterns of active brazing alloy 12 in multiple locations on a first surface of the copper sheet 10. Next, the screen printed copper sheet is positioned adjacent to an automated pick-and-place machine, which positions multiple ceramic substrates 16 above the first surface of the copper sheet 10, such that each substrate 16 at least partially overlaps brazing material 12.

The substrates 16 are then placed directly on the first surface of the copper sheet 10 by the pick-and-place machine, such that each substrate at least partially overlaps the patterned brazing material 12. The sheet 10 is then placed in a furnace, where it is heated until the brazing material 12 bonds the substrates 16 to the first surface of the copper sheet 10. After being removed from the oven, at least some of the copper sheet 10 is etched away to form leads 20 and expose portions of substrates 16, circuitry 17, and brazing alloy 12 to form circuitry. Finally, each individual leadframe assembly 22 is separated from the copper sheet 10 by cutting.

In another specific embodiment of the method 100, leadframe assemblies 22 are further processed prior to being separated from sheet 10 into individual leadframe assemblies. In yet another embodiment of method 100, sheet 10 is separated into manufacturable sections, each section containing multiple leadframe assemblies 22, for further processing (e.g., surface mounting of semiconductor devices onto assemblies 22), prior to separating individual leadframe assemblies 22 from copper sheet 10. For example, a thirty-six inch by thirty-six inch sheet of leadframe assemblies 22 could be divided into twelve inch by twelve inch sections, each containing leadframe assemblies 22. The separated twelve inch by twelve inch sections could then be further processed (e.g. surface mounting semiconductor devices onto assemblies 22) prior to separating individual leadframe assemblies 22 from each twelve inch by twelve inch section.

By using the method described above, leadframe assemblies can be formed without the use of less reliable solder joints. The method also enables cost-effective manufacturing of four-sided leadframe geometries. In addition, leadframe structures and circuit elements can be formed by etching away less expensive copper material, rather than by removing more expensive substrate material. The method also advantageously provides for cost-effective high-volume manufacturing of leadframe assemblies that offer reliable connections and contain multiple devices.

The above description is considered that of the preferred embodiments only. Modifications of the invention will occur to those skilled in the art and to those who make or use the invention. Therefore, it is understood that the embodiments shown in the drawings and described above are merely for illustrative purposes and not intended to limit the scope of the invention, which is defined by the following claims as interpreted according to the principles of patent law, including the doctrine of equivalents.

## Claims

1. A method for forming a leadframe assembly (22), comprising the steps of:
providing a sheet (10) comprising leadframe material;
depositing a brazing alloy (12) on a first surface of the sheet (10);
providing at least one substrate (16) having a first surface that is primarily planar;
placing the first surface of the at least one substrate (16) adjacent to the first surface of the sheet (10), such that at least a portion of the substrate (16) first surface overlaps, and is in contact with, the brazing alloy (12); and
heating the brazing alloy (12) to bond the first surface of the at least one substrate (16) to the first surface of the sheet (10).

2. The method of claim 1, further comprising the step of etching away at least some of the sheet (10).

3. The method of claim 1, wherein the sheet (10) comprises copper.

4. The method of claim 1, wherein the step of depositing the brazing alloy (12) comprises screen printing the brazing alloy (12).

5. The method of claim 1, wherein the surface of the at least one substrate (16) comprises a conductor.

6. The method of claim 1, wherein the sheet (10) comprises at least one leadframe.

7. The method of claim 1, wherein the at least one substrate (16) comprises AlN.

8. The method of claim 1, wherein the surface area of the first surface of the at least one substrate (16) is not greater than the surface area of the first surface of the sheet (10).

9. The method of claim 1, wherein the at least one substrate (16) comprises circuitry.

10. The method of claim 1, further comprising the step of providing an additional substrate (16) having a first surface that is primarily planar, and placing the first surface of the additional substrate (16) adjacent to the first surface of the sheet (10), such that at least a portion of the substrate (16) first surface overlaps, and is in contact with, brazing alloy (12).
